**Europäisches Patentamt**

**European Patent Office**

**Office européen des brevets**

(19)

(11) Numéro de publication: **0 044 528**
**B1**

(12) # FASCICULE DE BREVET EUROPEEN

(45) Date de publication du fascicule du brevet:
**16.05.84**

(51) Int. Cl.³: **G 01 R 21/00**

(21) Numéro de dépôt: **81105577.1**

(22) Date de dépôt: **16.07.81**

(54) **Dispositif de mesure de la puissance réactive monophasée d'un réseau électrique.**

(30) Priorité: **22.07.80 FR 8016110**

(43) Date de publication de la demande:
**27.01.82 Bulletin 82/4**

(45) Mention de la délivrance du brevet:
**16.05.84 Bulletin 84/20**

(84) Etats contractants désignés:
**BE CH DE FR GB IT LI**

(56) Documents cités:
**DE - A - 2 039 756**
**DE - A - 2 627 293**
**FR - A - 2 435 724**
**US - A - 3 793 593**

**CONTROL & INSTRUMENTATION, vol. 3, no. 3, mars 1971, LONDRES (GB) B.E. JONES: "Portable Clip-On A.C. Multimeter to Measure Parameters", pages 37-41**
**JOURNAL OF PHYSICS E, SCIENTIFIC INSTRUMENTS, vol. 10, no. 6, juin 1977, LONDRES (GB) D.W. AUCK et al.: "A Multiplier Wattmeter", pages 589-591**
**TECHNISCHE MITTEILUNGEN AEG-TELEFUNKEN, vol. 61, no. 6, juin 1971 BERLIN (DE) G. BREITENBERGER: "Verzögerungsarmer Wechselspannungs-Gleichspannungs-Umsetzer zur**

(73) Titulaire: **CGEE ALSTHOM Société anonyme dite:, 13, rue Antonin Raynaud, F-92309 Levallois-Perret (FR)**

(72) Inventeur: **Guilloux, Jean-Claude, 27 Domaine du Salbert Cravanche, F - 90300 Valdoie (FR)**

(74) Mandataire: **Weinmiller, Jürgen et al, Zeppelinstrasse 63, D-8000 München 80 (DE)**

(56) Documents cités: (suite)
**Darstellung von effectivwert, Wirk- und Blindleistung", pages 327-329**
**FREQUENZ, vol. 29, no. 5, mai 1975, BERLIN (DE) T. KALLFASS: "Temperatur-kompensierte RC-aktive Schaltungen in Dickschichttechnik", pages 147-151**

BUNDESDRUCKEREI BERLIN

# Dispositif de mesure de la puissance réactive monophasés d'un réseau électrique

Dans les réseaux qui subissent de fortes perturbations d'intensité, dans des portions de réseau proches de fours à arc par exemple, il est nécessaire de prévoir des dispositifs de régulation de compensation d'énergie réactive et pour cela, il convient d'utiliser des dispositifs de mesure de la puissance réactive absorbée par le circuit électrique et si l'on veut agir immédiatement, pour atténuer les fluctuations de tension sur le réseau, il faut que le dispositif de mesure soit très rapide.

On connaît un dispositif de mesure de puissance réactive qui comprend un premier circuit multiplicateur recevant en entrée d'une part une image de la tension après passage dans un circuit déphaseur de $\frac{\pi}{2}$ et d'autre part une image du courant et un second cicuit multiplicateur qui reçoit en entrée d'une part une image du courant après passage dans un circuit déphaseur de $\frac{\pi}{2}$ et d'autre part une image de la tension, on fait ensuite la différence, dans un amplificateur, entre les signaux de sortie du premier et du deuxième circuit multiplicateur.

Les termes en $2\omega$ résultant du produit en valeur instantanée du courant et de la tension sont éliminés par le fait que l'on utilise deux circuits multiplicateurs en sortie desquels les termes en $2\omega$ sont en opposition de phase et sont ainsi éliminés par soustration dans l'amplificateur. Cependant, dans un tel dispositif où le second circuit multiplicateur reçoit une image du courant, déphasé de $\frac{\pi}{2}$, il en résulte qu'une réponse à une perturbation de courant subit l'effet des constantes de temps du circuit déphaseur et, en régime transitoire, l'amplificateur qui réalise la soustraction des signaux de sortie des deux circuits multiplicateurs reçoit en entrée le signal provenant du premier circuit multiplicateur dont la réponse est instantanée et le signal du second circuit multiplicateur dont la réponse ne l'est pas. Il en résulte un écart transitoire qui fausse le signal de sortie et peut entraîner des dépassements très importants par rapport à la valeur réelle de la puissance réactive.

La présente invention a pour but a réaliser un dispositif ayant une réponse et sans dépassement de la valeur réelle de la puissance réactive, en régime transitoire de courant.

L'invention a donc pour objet un dispositif de mesure de la puissance réactive monophasée d'un réseau électrique de pulsation $\omega$, comportant un circuit multiplicateur recevant en entrée d'une part une image de la valeur instantanée de la tension du réseau après un passage préable dans un circuit déphaseur de $\frac{\pi}{2}$ en retard et d'autre part une image de la valeur instantanée du courant circulant dans ledit réseau, le signal de sortie du circuit multiplicateur compartant des termes en $2\omega$ et étant envoyé vers un filtre délivrant un signal de sortie dépouron des termes en $2\omega$, caractérisé en ce que ledit filtre est un filtre actif en double T ponté dont la première branche en T est constituée d'une première et d'une deuxième résistances situées dans la partie horizonale du T et d'un premier condensateur situé dans la partie verticale du T, ladite branche étant alimentée par un premier amplificateur opérationnel et dont la deuxième branche est constituée d'un second et d'un troisième condensateurs situés dans la partie horizontale du T et d'une troisième résistance située dans la partie verticale du T, ladite seconde branche étant alimentée par un second amplificateur opérationnel, la fréquence de rejet du filtre étant ajustable par des potentiomètres réglant le gain des deux dits amplificteurs opérationnels, qui sont alimentés par le signal de sortie du circuit multiplicateur.

Avantageusement, le dispositif comporte en outre un système de réglage de la sélectivité du filtre. Pour cela, le signal de sortie du filtre est appliqué à un troisième amplificateur opérationnel à forte résistance d'entrée et à gain unité, dont une partie du signal de sortie est appliqué entre le premier condensateur et la troisième résistance du filtre par l'intermédiaire d'un quatrième amplificateur opérationnel comportant un potentiomètre de réglage du gain.

Enfin, avantageusement le signal de sortie du troisième amplificateur opérationnel est envoyée vers un autre filtre qui est un filtre actif passe-bas du deuxième ordre à la sortie duquel on obtient le signal représentatif de la puissance réactive recherchée.

L'invention sera bien comprise à la lumière de la description ci-après faite en regard du dessin annexé dans lequel:

La figure 1 montre un schéma de principe d'un dispositif de mesure de puissance réactive monophasée selon l'art antérieur.

La figure 2 donne une représentation schématique de principe du dispositif de mesure de puissance réactive selon l'invention.

La figure 3 donne un exemple pratique de réalisation d'un dispositif selon l'invention.

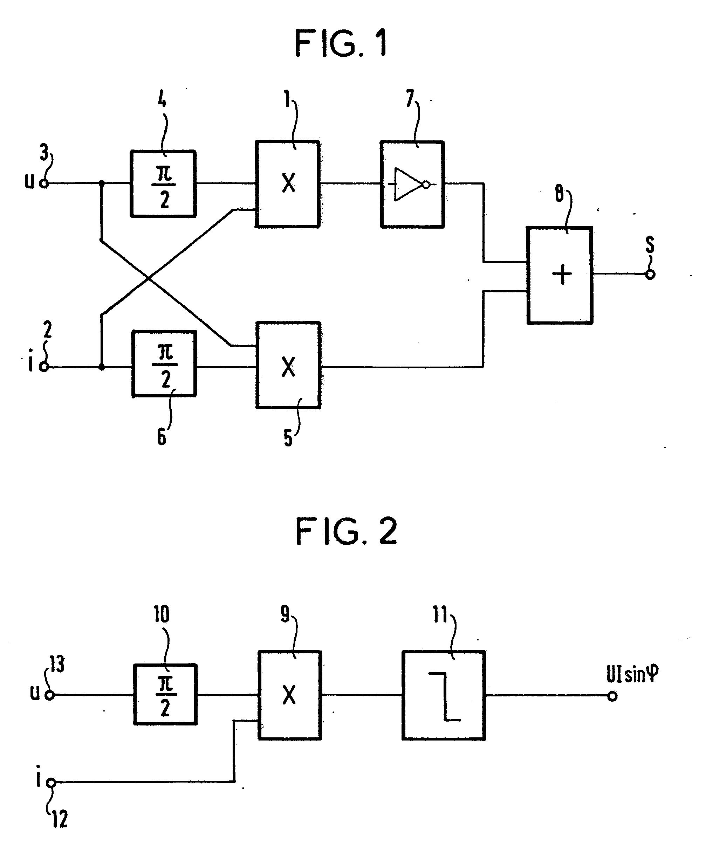

En se reportant à la figure 1 qui donne une représentation schématique d'un dispositif connu de mesure de puissance réactive, l'ensemble comporte deux voies de mesure. La première comprend un circuit multiplicateur 1 recevant en entrée d'une part un signal image du courant circulant dans le réseau dont on veut connaître la puissance réactive absorbée, ce signal étant appliqué à la borne 2 et d'autre part un signal image de la tension appliqué à la borne 3. Un circuit déphaseur 4, déphasant la tension de $\frac{\pi}{2}$ est interposé entre la borne 3 et le circuit multiplicateur 1. La seconde voie comprend également un circuit multiplicateur 5 qui reçoit en entrée d'une part une image de la tension, appliqué à la borne 3 et d'autre part une image du courant appliquée à la borne 2, un circuit déphaseur 6 étant interposé entre le signal image du courant appliqué à la borne 2 et le circuit multiplicateur 5 déphasant le signal image du courant de $\frac{\pi}{2}$. Les signaux images de la tension et du courant appliqués aux bornes 3 et 2 sont de la forme respectivement

$$u = U\sqrt{2} \sin \omega t$$
et
$$i = I\sqrt{2} \sin (\omega t - \varphi);$$

dans ces formules, u représente la valeur instantanée de la tension, i la valeur instantanée du courant, $\omega$ la pulsation, $\varphi$ le déphasage entre le courant et la tension, U la valeur efficace de la tension et I la valeur efficace du courant.

A la sortie du dispositif multiplicateur 1 est disposé un circuit inverseur 7 qui donne en sortie un signal égal à 2 UI cos $\omega t$ sin $(\omega t - \varphi)$ qui est envoyé à l'une des entrée d'un circuit sommateur inverseur 8. Le circuit multiplicateur 5 donne en sortie un signal égal à

$$-2 \text{ UI} \sin \omega t \cos (\omega t - \varphi)$$

qui est appliqué à une seconde entrée du circuit sommateur inverseur 8. En sortie du circuit 8, on obtient le signal désiré: 2 UI sin $\varphi$ donc directement proportionnel à la puissance réactive. Cependant, dans ce dispositif, à cause des constantes de temps dûes au circuit déphaseur 6, la réponse, en sortie du circuit multiplicateur 5, à une variation du courant i n'est pas instantanée alors qu'en sortie du circuit multiplicateur 1, la réponse à une variation de courant est pratiquement instantanée, il s'ensuit qu'en régime transitoire de courant, l'amplificateur 8 fait la somme d'une réponse qui est instantanée et d'une réponse qui ne l'est pas, le signal de sortie est donc faussé et cela peut entraîner des dépassements très importants par rapport à la valeur réelle actuelle de la puissance réactive. Cette mauvaise qualité du dispositif en régime transitoire rend son emploi difficile dans des régulateurs de compensateurs statiques d'énergie réactive destinés à des réseaux fortement perturbés en courant, par des fours à arc par exemple, et nécessitant des systèmes de mesure très rapides.

La figure 2 donne un schéma de principe d'un dispositif de mesure de la puissance réactive conforme à l'invention.

Il comprend essentiellement un circuit multiplicateur 9, un circuit déphaseur 10 et un filtre 11. Le circuit multiplicateur 9 reçoit directement une image du courant instantanée de la forme

$$i = I\sqrt{2} \sin (\omega t - \varphi)$$

appliqué à la borne 12 et une image de la tension instantanée de la forme

$$u = U\sqrt{2} \sin \omega t$$

déphasée de $\frac{\pi}{2}$ dans le circuit déphaseur 10 et appliqué à la borne 13. A la sortie du circuit multiplicateur 9, on obtient un signal égal à

$$-\text{UI} \sin (2\omega t - \varphi) + \text{UI} \sin \varphi.$$

Le filtre 11 qui suit est calculé pour éliminer le premier terme

$$\text{UI} \sin (2\omega t - \varphi)$$

de pulsation $2\omega$.

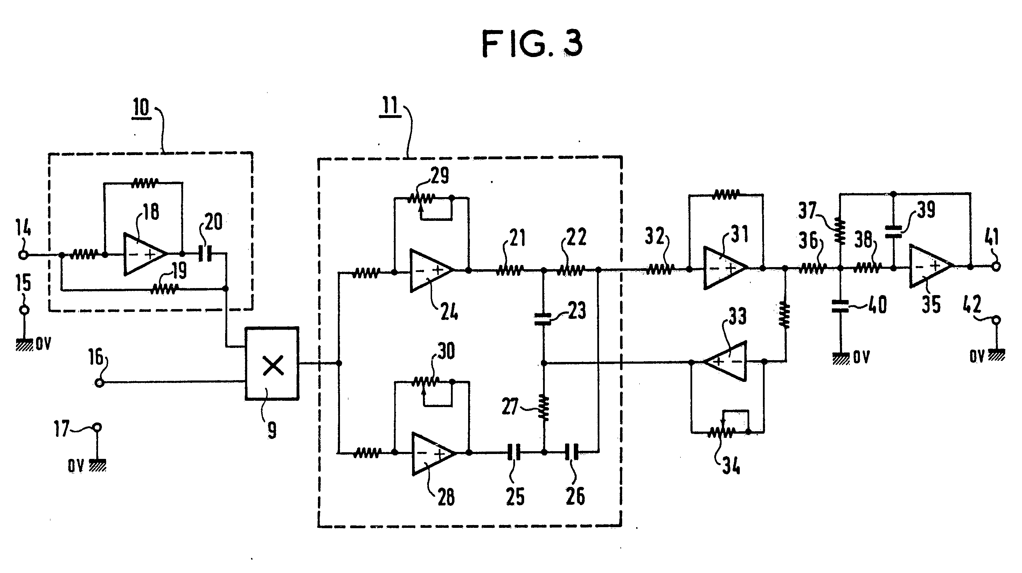

La figure 3 donne une représentation schématique d'un dispositif complet conforme à l'invention.

En entrée du dispositif sont appliquées, d'une part entre les bornes 14 et 15 une image de la tension et d'autre part entre les bornes 16 et 17 une image du courant du réseau électrique dont on désire connaître la puissance réactive absorbée. Ces images tension et courant proviennent par exemple de transformateurs de tension et de courant.

Le dispositif comprend essentiellement:

- un circuit déphaseur 10 pur actif qui déphase la mesure de tension en quadrature. Ce circuit est constitué d'un amplificateur opérationnel 18 en gain unité, associé au circuit déphaseur composé d'une résistance 19 et d'un condensateur 20.
- un circuit multiplicateur 9 analogique qui multiplie la tension de sortie du circuit déphaseur 10 par la tension entre les bornes 16 et 17 qui est proportionnelle à la mesure du courant (image courant).
- un filtre actif 11 en double T ponté, dont la première branche en T est constituée de résistances 21 et 22, et d'un condensateur 23 et est alimentée par un amplificteur opérationnel 24 et dont la seconde branche en T est constituée de condensateurs 25 et 26 et d'une résistance 27 et est alimentée par un amplificateur opérationnel 28.

Ce filtre élimine d produit effectué par le circuit multiplicateur 9 la composante à fréquence double de celle des signaux d'entrée. La fréquence éliminée est donc double de celle des mesures tension et courant, elle est ajustable par des potentiomètres 29 et 30 réglant le gain des amplificateurs 24 et 28.

Le signal de sortie du filtre 11 est appliqué à un amplificateur opérationnel 31 à forte résistance d'entrée 32, dont le gain est unité.

Une partie du signal de sortie de l'amplificateur 31 est appliquée entre le condensateur 23 et la résistance 27 du filtre 11 par l'intermédiaire d'un amplificateur opérationnel 33 ce qui augmente la sélectivité du filtre; cette dernière est ajustable par un potentiomètre 34 réglant le gain de l'amplificateur 33.

— un filtre actif passe-bas du deuxième ordre qui diminue, du signal de sortie de l'amplificateur 31, les composantes harmoniques de rang supérieur à deux, présentes dans le produit effectué par le circuit multiplicateur 9. Ce filtre est constitué d'un amplificateur opérationnel 35 associé à des circuits déphaseurs à résistances 36, 37, 38 et à condensateurs 39 et 40. Sa fréquence de coupure est égale à la fréquence de rejet du filtre 11. En sortie, entre les bornes 41 et 42 on obtient une tension continue constituant la grandeur de sortie du système, proportionnelle à la puissance réactive absorbée par le réseau de courant i et de tension u.

Dans le dispositif de l'invention ci-dessus décrit, la grandeur de sortie est une tension continue affectée d'une très faible ondulation résiduelle. Elle est facilement utilisable par un régulateur analogique.

La mesure reste valable même si le courant absorbé n'est pas sinusoïdal pourvu qu'il soit alternatif symétrique et que la tension soit sinusoïdale. Dans ces conditions, aucun filtre n'est nécessaire sur la mesure courant.

L'utilisation d'un filtre en double T ponté à forte sélectivité permet un temps de réponse global à un échelon d'amplitude ou de phase du courant de 10 ms environ, sans dépassement, dans toute la plage de mesure.

## Revendications

1. Dispositif de mesure de la puissance réactive monophasée d'un réseau électrique de pulsation $\omega$ comportant un circuit multiplicateur (9) recevant en entrée d'une part une image de la valeur instantanée de la tension (u) du réseau après un passage préalable dans un circuit déphaseur (10) de $\frac{\pi}{2}$ en retard et d'autre part une image de la valeur instantanée du courant (i) circulant dans ledit réseau, le signal de sortie du circuit multiplicateur (9) comportant des termes en $2\omega$ et étant envoyé vers un filtre (11) délivrant un signal de sortie dépourvu des termes en $2\omega$, caractérisé en ce que ledit filtre (11) est un filtre actif en double T ponté dont la première branche en T est constituée d'une première (21) et d'une deuxième résistances (22) situées dans la partie horizonale du T et d'un premier condensateur (23) situé dans la partie verticale du T, ladite première branche étant alimentée par un premier amplificateur opérationnel (24) et dont la deuxième branche est constituée d'un second (25) et d'un troisième (26) condensateurs situés dans la partie horizonale du T et d'une troisième résistance (27) située dans la partie verticale du T, ladite seconde branche étant alimentée par un second amplificateur opérationnel (28), la fréquence de rejet du filtre étant ajustable par des potentiomètres (29, 30) réglant le gain des deux dits amplificateurs opérationnels (24, 28), qui sont alimentés par le signal de sortie du circuit multiplicateur (9).

2. Dispositif de mesure de la puissance réactive selon la revendication 1, caractérisé en ce que le signal de sortie du filtre (11) est appliqué à un troisième amplificateur opérationnel (31) à forte résistance d'entrée (32) et à gain unité dont une partie du signal de sortie est appliquée entre le premier condensateur (23) et la troisième résistance (27) du filtre par l'intermédiaire d'un quatrième amplificateur opérationnel (33) comportant un potentiomètre (34) de réglage du gain.

3. Dispositif de mesure de la puissance active selon la revendication 2, caractérisé en ce que le signal de sortie du troisième amplificateur opérationnel (31) est envoyé vers un autre filtre, qui est un filtre actif passe-bas du deuxième ordre, le signal de sortie dudit autre filtre étant une image de la puissance réactive du réseau.

## Patentansprüche

1. Vorrichtung zur Messung der einphasigen Reaktivleistung eines elektrischen Netzes der Kreisfrequenz $\omega$, mit einem Multiplikationsschaltkreis (9), dem eingangsseitig einerseits ein Bild des Augenblickswerts der Spannung (u) des Netzes nach vorherigem Durchlauf durch einen $\frac{\pi}{2}$-Phasenverzögerungsschaltkreis (10) und andererseits ein Bild des Augenblickswerts des in dem Netz fließenden Stroms (i) zugeführt wird und dessen Ausgangssignal einem Filter (11) zugeführt wird, das ein Ausgangssignal ohne Anteile der Kreisfrequenz ($2\omega$) liefert, dadurch gekennzeichnet, daß das Filter (11) ein aktives Filter vom Typ »doppeltes T überbrückt« ist, dessen erster T-Zweig aus einem ersten (21) und einem zweiten Widerstand (22), die im waagerechten Teil des T liegen, und aus einem ersten Kondensator (23) besteht, der im senkrechten Teil des T liegt, wobei der erste Zweig von einem ersten Operationsverstärker (24) gespeist wird, während der zweite Zweig von einem zweiten (25) und dritten Kondensator (26), die im waagerechten Teil des T liegen, und von einem dritten Widerstand (27) gebildet wird, der im senkrechten Teil des T liegt, wobei der zweite Zweig von einem zweiten Operationsverstärker (28) gespeist wird, und daß die Sperrfrequenz des Filters an Potentiometern (29, 30) einstellbar ist, mit denen der Verstärkungsgrad der Operationsverstärker (24, 28) verändert wird, wobei die Verstärker (24, 28) das Ausgangssignal des Multiplikationsschaltkreises zugeführt erhalten.

2. Vorrichtung zur Messung der Reaktivleistung nach Anspruch 1, dadurch gekennzeichnet, daß das Ausgangssignal des Filters (11) an einen dritten Operationsverstärker (31) mit großem Eingangswiderstand (32) und Einheitsverstärkung angelegt wird und daß ein Teil von dessen Ausgangssignal zwischen den ersten Kondensator (23) und den dritten Widerstand (27) des Filters über einen vierten Operationsverstärker (33) angelegt wird, der ein Potentiometer (34) zur Einstellung des Verstärkungsgrades besitzt.

3. Vorrichtung zur Messung der Reaktivleistung nach Anspruch 2, dadurch gekennzeichnet, daß das Ausgangssignal des dritten Operationsverstärkers (31) an ein anderes Filter angelegt wird, das ein aktives Tiefpaßfilter zweiter Ordnung ist, wobei das Ausgangssignal dieses anderen Filters ein Bild der Reaktivleistung des Netzes ist.

## Claims

1. A device for measuring the monophase reactive power of an electric network of the pulsation frequency $\omega$, comprising a multiplier circuit (9) which receives at its inputs on the one hand a picture of the instant value of the network voltage (u) after having traversed a $\frac{\pi}{2}$-delay circuit (10), and on the other hand a picture of the instant value of the current (i) circulating in said network, the output signal of the multiplier circuit (9) comprising terms of a pulsation frequency $2\omega$ and being sent to a filter (11) which delivers an output signal free of $(2\omega)$-terms, characterized in that said filter (11) is an active filter of the bridged double T type, the first T-branch of which consists of a first (21) and a second resistor (22) located in the horizontal part of the T and of a first capacitor (23) located in the vertical part of the T, the first branch being fed by a first operational amplifier (24), whereas the second branch consists of a second (25) and third capacitor (26) located in the horizontal part of the T, and of a third resistor (27) located in the vertical part of the T, said second branch being fed by a second operational amplifier (28), the rejection frequency of the filter being adjustable by means of potentiometers (29, 30) adjusting the gain of said two operational amplifiers (24, 28) which are fed by the output signal of the multiplier circuit (9).

2. A device for measuring the reactive power according to claim 1, characterized in that the output signal of the filter (11) is applied to a third operational amplifier (31) having a high input impedance (32) and unitary gain, a part of the output signal of which is applied between the first capacitor (23) and the third resistor (27) of the filter via a fourth operational amplifier (33) which is provided with a potentiometer (34) for adjusting the gain.

3. A device for measuring the reactive power according to claim 2, characterized in that the output signal of the third operational amplifier (31) is sent to a further filter which is an active low-pass filter of the second order, the output signal of said further filter being a picture of the reactive power of the network.

# FIG. 1

# FIG. 2

# FIG. 3